# EUROPEAN PATENT SPECIFICATION

(11) **EP 4 447 094 B1**
(45) Date of publication and mention of the grant of the patent: **29.04.2026**
(21) Application number: 24163133.2
(22) Date of filing: 13.03.2024
(51) Int. Cl.: H01L 21/48, H01L 23/495, H01L 21/56

(54) **A METHOD OF MANUFACTURING SEMICONDUCTOR DEVICES AND CORRESPONDING SEMICONDUCTOR DEVICE**
VERFAHREN ZUR HERSTELLUNG VON HALBLEITERBAUELEMENTEN UND ZUGEHÖRIGES HALBLEITERBAUELEMENT
PROCÉDÉ DE FABRICATION DE DISPOSITIFS SEMI-CONDUCTEURS ET DISPOSITIF SEMI-CONDUCTEUR CORRESPONDANT

(30) Priority: 29.03.2023 IT 202300006039
(43) Date of publication of application: 16.10.2024
(73) Proprietor: STMicroelectronics International N.V., 1228 Plan-les-Ouates, Geneva (CH)
(72) Inventor: BELLIZZI, Antonio, 20093 Cologno Monzese (Milano) (IT); CATALANO, Guendalina, 20125 Milano (IT)
(74) Representative: Buzzi, Notaro & Antonielli d'Oulx S.p.A.

(56) References cited:
- US-A1- 2022 077 086
- US-A1- 2022 344 173
- US-A1- 2022 384 209

## Description

### Technical field

The description relates to manufacturing semiconductor devices.

Solutions as described herein can be applied to power integrated circuit (IC) semiconductor devices such as power QFN packages, for automotive or industrial products, for instance.

### Background

In current manufacturing processes of (IC) semiconductor devices, multiple devices are concurrently processed and finally singulated into individual devices.

During processing, a plurality of substrates (leadframes) for individual devices are held together in a leadframe strip using metallic connecting structures including (sacrificial) connecting bars running along the periphery of each device.

Prior to the singulation step, a plating step can be performed in order to plate the leadframe bottom surface with a metallic (solderable) layer, of tin, for instance.

Processing of certain devices may be facilitated by providing relatively large connecting bars **(e.g.,** wider than 200 microns) that are exposed during the plating step. This results in the connecting bars being plated during the plating step with a fairly large amount of metal accumulated on the connecting bars.

During the singulation step a blade is used to remove the connecting bars and the solderable metallic layer plated thereon. Due to the amount of metal accumulated on the connecting bars, the action of the blade during the singulation step may produce flakes or filaments that undesirably "bridge" neighboring leads causing a short circuit therebetween.

Such an undesired electrical coupling (short) causes rejection and/or failure of the device.

Documents US 2022/384209 A1, US 2022/344173 A1, and US 2022/077086 A1 are exemplary of technical background of interest for the invention.

### Object and summary

Solutions as described herein aim at addressing the issues discussed in the foregoing.

Such an object can be achieved via a method having the features set forth in the claims that follow.

One or more embodiments relate to a corresponding (integrated circuit) semiconductor device.

The claims are an integral part of the technical teaching provided in respect of the embodiments.

In solutions as described herein, a processing step is provided in order to counter filaments/flakes formation which could cause failure of the device.

In solutions as described herein, metallic material accumulated on the back/bottom surface of the connecting bars during the plating step is removed before the singulation step in order to counter flakes/filaments formation.

In solutions as described herein, metallic material may be removed from the back/bottom surface of the connecting bars via laser ablation.

### Brief description of the several views of the drawings

One or more embodiments will now be described, by way of example only, with reference to the annexed figures, wherein:
Figure 1 is a plan view illustrative of a portion of a leadframe strip,
Figure 2 is a plan view illustrative of a final singulation step performed on the leadframe strip illustrated in Figure 1,
Figure 3 is a plan view illustrative of a portion of a leadframe strip processed according to embodiments of the present description, and
Figure 4 is a plan view illustrative of a final singulation step performed on the leadframe strip illustrated in Figure 3.

Corresponding numerals and symbols in the different figures generally refer to corresponding parts unless otherwise indicated.

The figures are drawn to clearly illustrate the relevant aspects of the embodiments and are not necessarily drawn to scale.

The edges of features drawn in the figures do not necessarily indicate the termination of the extent of the feature.

### Detailed description

In the ensuing description one or more specific details are illustrated, aimed at providing an in-depth understanding of examples of embodiments of this description. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment.

The headings/references used herein are provided merely for convenience and hence do not define the extent of protection or the scope of the embodiments.

For simplicity and ease of explanation, throughout this description, and unless the context indicates otherwise, like parts or elements are indicated in the various figures with like reference signs, and a corresponding description will not be repeated for each and every figure.

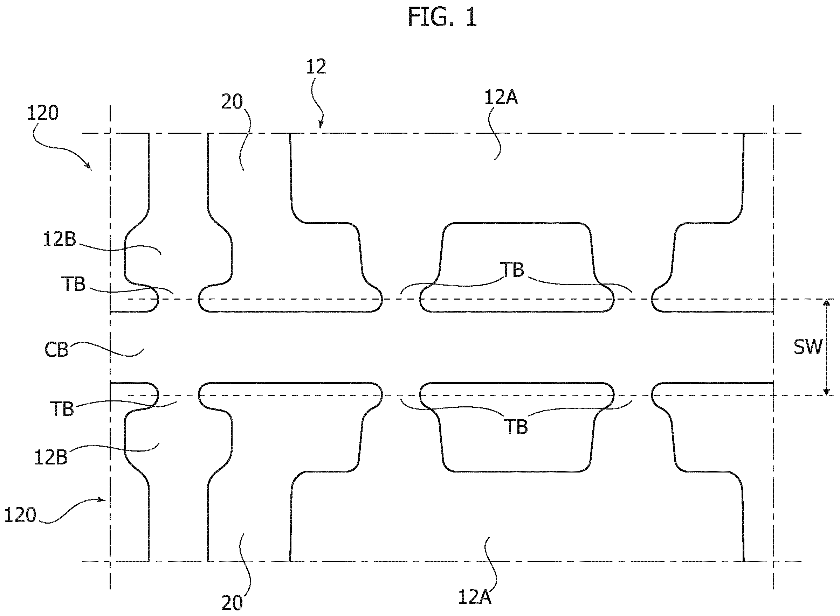

Figure 1 illustrates the back/bottom surface of a portion of a leadframe strip 12 including portions of two neighboring (individual) leadframes or substrates for respective (integrated circuit) semiconductor devices, not visible in their entirety.

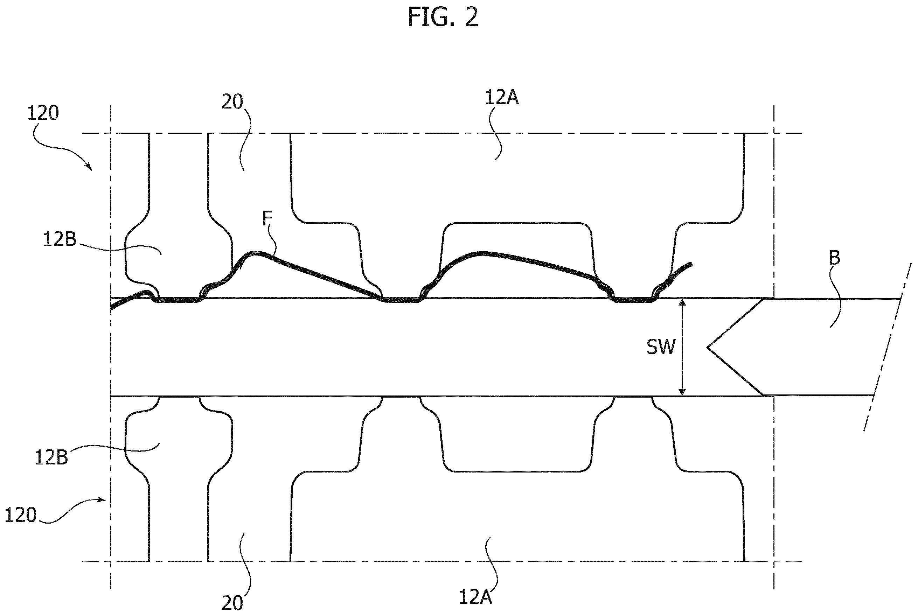

These portions of leadframes or substrates are indicated with the reference 120 in the figures, e.g., in Figure 2, which refers to a condition after singulation.

In fact, in current manufacturing processes of (integrated circuit) semiconductor devices plural devices/leadframes are processed concurrently. Concurrent processing of a plurality of devices is achieved by providing a common substrate (e.g., a leadframe strip) comprising a plurality of individual substrate for each device.

The designation "leadframe" (or "lead frame") is currently used (see, for instance the USPC Consolidated Glossary of the United States Patent and Trademark Office) to indicate a metal frame that provides support for an integrated circuit chip or die as well as electrical leads to interconnect the integrated circuit in the die or chip (the terms chip/s and die/dice are regarded as synonymous) to other electrical components or contacts.

Essentially, a leadframe comprises an array of electrically-conductive formations (or leads, e.g., 12B) that from an outline location extend inwardly in the direction of a semiconductor chip or die thus forming an array of electrically-conductive formations from a die pad (e.g., 12A in Figure 1) configured to have at least one (integrated circuit) semiconductor chip or die attached on the top/front surface thereof. This may be via conventional means such as a die attach adhesive (a die attach film or DAF, for instance).

In certain cases, a leadframe can be of the pre-molded type, that is a type of leadframe comprising a sculptured metal (e.g., copper) structure formed by etching a metal sheet and comprising empty spaces that are filled by an insulating compound (a resin, for instance) "pre-molded" on the sculptured metal structure.

In order to concurrently process several devices, several leadframes are arranged in a leadframe strip 12 and held together via sacrificial connecting bars CB running at the periphery of the individual leadframes 120.

Leadframes 120 are connected to the connecting bars via so-called tie bars TB, bridge-like formations that connect the pads (e.g., 12A) or the leads (e.g., 12B) of a leadframe to the connecting bars.

As known to those of skill in the art, current manufacturing processes of (integrated circuit, IC) semiconductor devices may involve:
arranging one or more semiconductor (e.g., silicon) die on the top/front surface of a corresponding die mounting location (e.g., die pads 12A),
providing electrical coupling between the die/dice and selected one of the leads 12B via wire bonding or, as it is the case in power devices, via clips or ribbons,
molding an insulating molding compound **(e.g., an** epoxy resin) on the leadframe strip 12 having the dice arranged on the top/front surface thereof to provide a protective plastic package to the devices,
a plating step wherein a solderable electrically conductive layer **(e.g.,** a tin layer) is plated on the bottom/back surface of the leadframes 12, and
a final singulation step wherein the processed leadframe strip 12 is cut (e.g., via sawing) into individual devices (with individual leadframes 120).

The sequence of steps just described is merely exemplary insofar as, for example, additional processing steps may be envisaged.

As noted, processing steps as described so far are otherwise conventional in the art, which makes it making unnecessary to provide a more detailed description herein.

In various embodiments, other techniques **(e.g.,** printing) can be adopted in the place of plating to provide a solderable metallic layer on the back or bottom surface of the substrate 120.

Figure 1 illustrates the back/bottom surface of portions of a leadframe strip 12 after a plating step has been performed to plate a solderable metallic **(e.g.,** tin) layer. The leadframe strip 12 of Figure 1 is intended to give rise to two (individual) adjacent/neighboring leadframes 120 as illustrated in Figure 2 in response to singulation.

Singulation is performed after dice/chips are arranged on the top/front surface of the corresponding die mounting locations (e.g., the die pads 12A) and a plastic encapsulation is molded onto the assembly. The dice/chips are assumed to be arranged on the front or top surface of the leadframe strip 12/individual leadframes 120. Thus, they are not visible in figures such as Figures 1 and 2, which are (plan) views of the back or bottom surface. Conversely, the molding compound 20 of the encapsulation may be at least partly visible also on the back/bottom surface of the leadframe strip 12.

As known to those skilled in the art, an electrically conductive layer of, for example, tin may enhance solderability of the device onto support substrate like a printed circuit board (PCB), for instance.

In certain embodiments, the leadframe portion indicated with the reference 12A in Figure 1 and described throughout as a die pad may also be a power lead.

This can be the case, for instance, of a power device, where the current(s) transferred from a (power) die to the power output leads of the device can be significant and leads with a larger contact area may be used for that purpose.

Consequently, it will be understood that the leadframe portion indicated with the reference 12A in Figure 1 and described throughout as a die pad may also be a (power) output lead.

A processing flow as consider so far may involve a plating step wherein the connecting bars CB are exposed (that is, left uncovered by the molding compound) at the back/bottom surface of the leadframe strip 12.

In the case exemplified in Figure 1 connecting bars CB and tie bars TB are exposed during the plating step and are thus plated with a solderable metallic layer.

Depending on the device design, connecting bars CB as exemplified in Figure 1 may be relatively large (e.g., wider than 200 microns). A fairly large amount of metal (e.g., tin) can thus accumulate on the bottom/back surface during the plating step.

As discussed, after the plating step, the leadframe strip 12 is cut (e.g., via a sawing blade B: for simplicity this is visible only in Figure 2) in order to singulate the strip into individual devices (with individual substrates/leadframes 120).

In the singulation step the blade B cuts the connecting bars CB along their length (over a region having a width indicated as SW) thus removing the connecting bars CB as well as a portion of the tie bars TB connected thereto.

Figure 2 illustrates the same portion of a leadframe strip 12 as exemplified in Figure 1 after sawing/cutting along the sawing width SW; the two adjacent/neighboring leadframes 120 are separated as a result of the removal of the connecting bars CB.

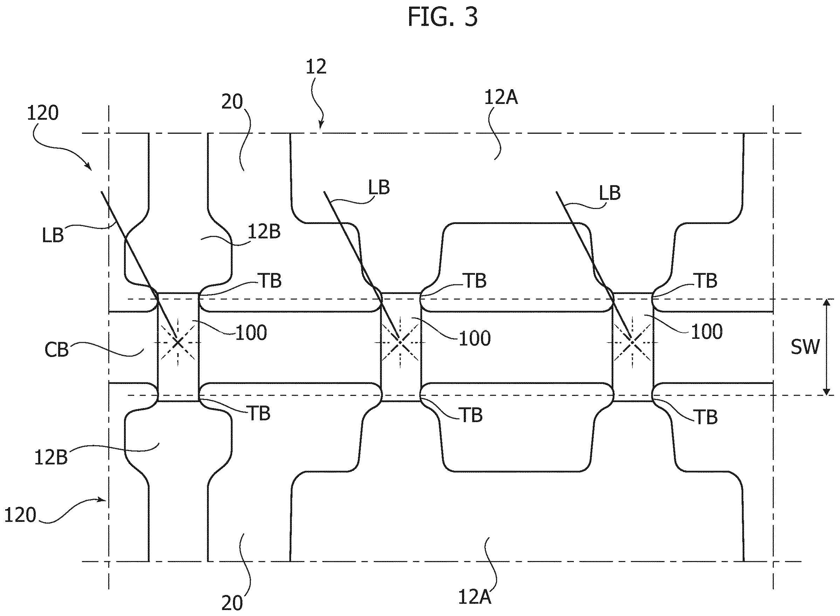

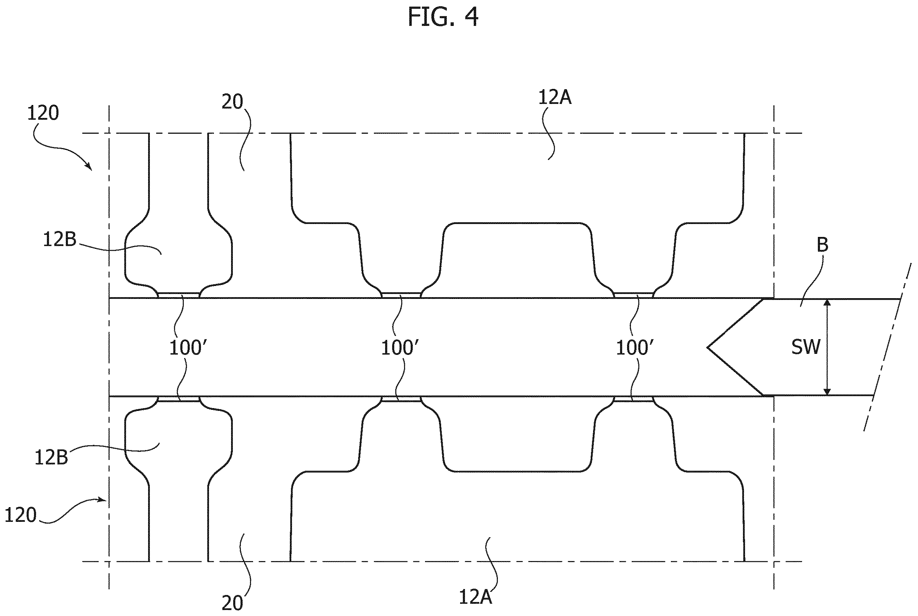

Figure 2 (and Figures 3 and 4 as well) are thus again illustrative of a method where a plurality of semiconductor dice (chips) are arranged onto a first surface of a common electrically conductive substrate (e.g., a leadframe 12).

The common substrate 12 has a second surface opposite the first surface and comprises adjacent substrate portions 120 having mutually facing sides with elongate sacrificial connecting bars CB extending therebetween.

A solderable metallic layer (e.g., tin) is grown (e.g., plated) on the second surface of the common electrically conductive substrate 12 with the solderable metallic layer extending (also) over the connecting bars CB.

As a consequence of the action of the blade B and due to the amount of solderable metallic material plated on the back/bottom surface of the leadframes in the leadframe strip 12, filaments F of solderable metallic material may form starting from a die pad 12A (or from a lead 12B).

As illustrated in Figure 2, such filaments or flakes F may undesirably establish electrical contact between neighboring electrically conductive formations such as die pads 12A or power lead 12B. This results in undesired electrical coupling (short-circuit) therebetween, which may cause failure (and rejection) of the final device.

It is observed that formation of such filaments F is a major cause of rejection of when processing certain types of IC semiconductor devices.

As discussed, a possible conventional approach to counter filaments F formation involves reducing in as much as possible the thickness of the solderable metallic layer deposited on the back/bottom surface of the leadframe 12 during the plating step.

It is however noted that:
the thickness of the solderable layer cannot be reduced beyond a certain limit as this would cause solderability issues when soldering the device to the final substrate (e.g., a PCB); and
reducing the thickness of the solderable layer reduces formation of filaments F (thus leading to lower defect ratios), but does not provide a completely adequate solution to the problem of filament formation.

In solutions as described herein, formation of filaments F is countered by (selectively) removing the solderable metallic layer deposited on the back/bottom surface of the connecting bars CB, from at least part of the length the sacrificial connecting bars CB.

As illustrated in Figure 3, removing the solderable metallic layer from the connecting bars CB may be advantageously limited to particular locations 100, namely at tie bars TB that are observed to provide "anchor points" for filament formation.

As exemplified in Figure 3, in solutions as described herein, the solderable metallic layer (e.g., tin) may be advantageously removed at the locations 100 via laser ablation - as schematically indicated by reference LB - during an (additional) processing step that can be performed prior to the final singulation step.

In various embodiments, other techniques (e.g., etching) can be adopted to selectively remove the solderable metallic layer from the locations 100.

In solutions as described herein, formation of filaments F is thus countered in so far as (e.g., prior to the singulation step) the solderable metallic layer is removed from selected locations 100 of the connecting bars CB; the full thickness of the solderable metallic layer is removed, thus leaving uncovered, that is exposed, the metallic material of the leadframe strip 12 underneath.

In examples as considered herein, the solderable metallic layer may be tin and the leadframe 12 copper. In these examples, copper will be exposed at the (ablated) regions 100, while the rest of the leadframe strip 12 will be covered with tin. Different materials or alloys may be used depending on application options.

In examples as considered herein, cutting the leadframe 12 providing (prior to singulation) a common electrically conductive substrate having the plurality of semiconductor dice arranged onto the first surface thereof to provide singulated individual semiconductor devices is (e.g., via the blade B over a width SW) along the length of the elongate sacrificial connecting bars CB having the solderable metallic layer removed from at least part of the length the sacrificial connecting bars CB.

In examples as considered herein, the solderable metallic layer is removed **(e.g.,** via laser ablation LB) at selected locations 100 distributed along the length of the sacrificial connecting bars CB.

As illustrated, the solderable metallic layer can be removed from the sacrificial connecting bars CB at tie bars TB that couple the elongate sacrificial connecting bars (CB) to adjacent substrate portions 120 in the common electrically conductive substrate (leadframe 12).

As illustrated in Figure 3, the regions 100 wherein the solderable metallic material has been removed may extend beyond the width of the connecting bars CB into the tie bars TB. In particular, as illustrated in Figure 3, the regions 100 may extend beyond the sawing width SW (in dashed lines in Figure 3).

After removing the solderable metallic layer at regions 100, a singulation step may be performed, wherein the sacrificial connecting bars CB are removed (via sawing, for instance). Having removed the full thickness of the solderable metallic layer at regions 100, the blade will not contact the solderable metallic layer at the tie bars TB thus reducing (notionally eliminating) the risk of filament formation.

As illustrated in Figure 4, a portion 100' of the regions wherein the solderable metallic layer has been removed may be left (and thus remain observable) at the surface of the individual leadframe of the final device and it will be visible on the bottom and side surfaces thereof.

That is, the solderable metallic layer can be removed from the distal ends 100' of the tie bars TB that (in the leadframe 12 prior to singulation) couple the elongate sacrificial connecting bars CB to adjacent substrate portions 120 in the common electrically conductive substrate 12.

It is noted that removing the solderable metallic material from the regions 100 of the connecting bars CB does not compromise the solderability of the final device; apart from the small portion 100' at the distal ends of the remainders of the tie bars TB, the bottom surface of the leadframes 120 is plated with a solderable metallic layer of a desired thickness.

Such processing may result in a (final) singulated semiconductor device that comprises one or more semiconductor dice (or chips) arranged onto a first surface of a portion 120 of an electrically conductive substrate (such as a leadframe 12) having a second surface opposite the first surface with a solderable metallic layer grown on the second surface.

In such a final singulated semiconductor device, the respective portion (leadframe portion 120) of electrically conductive substrate comprises remainders of the tie bars (the distal ends 100') distributed along the length of and protruding from at least one side of that leadframe portion. The solderable metallic layer is absent from these remainders of tie bars 100' in so far as the solderable metallic layer was removed (e.g., laser ablated) from these distal ends 100'.
The extent of protection is determined by the annexed claims.

## Claims

1. A method, comprising:
arranging a plurality of semiconductor dice onto a first surface of a common electrically conductive substrate (12), wherein the common substrate (12) has a second surface opposite the first surface and comprises adjacent substrate portions (120) having mutually facing sides with elongate sacrificial connecting bars (CB) extending between adjacent mutually facing sides, with a solderable metallic layer grown on the second surface of the common electrically conductive substrate (12) the solderable metallic layer extending over the connecting bars (CB),
removing the solderable metallic layer from at least part (100) of the length the sacrificial connecting bars (CB), and
cutting (B, SW) the common electrically conductive substrate (12) having the plurality of semiconductor dice arranged onto the first surface thereof to provide singulated individual semiconductor devices, wherein cutting is along the length of the elongate sacrificial connecting bars (CB) having the solderable metallic layer removed from at least part (100) of the length the sacrificial connecting bars (CB).

2. The method of claim 1, wherein the solderable metallic layer comprises tin.

3. The method of claim 1 or claim 2, wherein the method comprises growing the solderable metallic layer on the second surface of the common electrically conductive substrate (12) via plating.

4. The method of any of the previous claims, comprising removing the solderable metallic layer via laser ablation (LB).

5. The method of any of the previous claims, comprising removing the solderable metallic layer at selected locations (100) distributed along the length the sacrificial connecting bars (CB).

6. The method of claim 5, comprising removing the solderable metallic layer from the sacrificial connecting bars (CB) at tie bars (TB) coupling the elongate sacrificial connecting bars (CB) to adjacent substrate portions (120) in the common electrically conductive substrate (12).

7. The method of claim 6, comprising removing the solderable metallic layer from distal ends (100') of the tie bars (TB) coupling the elongate sacrificial connecting bars (CB) to adjacent substrate portions (120) in the common electrically conductive substrate (12).

8. A semiconductor device obtainable with the method of claim 7, wherein the semiconductor device comprises at least one semiconductor die arranged onto a first surface of a portion (120) of an electrically conductive substrate (12) having a second surface opposite the first surface with a solderable metallic layer grown on the second surface, wherein the portion (120) of electrically conductive substrate (12) comprises remainders of tie bars (100') distributed along the length of and protruding from at least one side thereof, wherein the solderable metallic layer is absent from said remainders of tie bars (100').

## Patentansprüche

1. Verfahren, umfassend:
Anordnen einer Vielzahl von Halbleiterchips auf einer ersten Oberfläche eines gemeinsamen elektrisch leitenden Substrats (12), wobei das gemeinsame Substrat (12) eine zweite Oberfläche gegenüber der ersten Oberfläche aufweist und benachbarte Substratabschnitte (120) umfasst, die einander gegenüberliegende Seiten mit länglichen Opferverbindungsstäben (CB) aufweisen, die sich zwischen benachbarten, einander gegenüberliegenden Seiten erstrecken, wobei eine lötbare Metallschicht auf der zweiten Oberfläche des gemeinsamen elektrisch leitenden Substrats (12) aufgewachsen ist, wobei sich die lötbare Metallschicht über die Verbindungsstäbe (CB) erstreckt,
Entfernen der lötbaren Metallschicht von mindestens einem Teil (100) der Länge der Opferverbindungsstäbe (CB), und Schneiden (B, SW) des gemeinsamen elektrisch leitenden Substrats (12), das die Vielzahl von Halbleiterchips aufweist, die auf der ersten Oberfläche davon angeordnet sind, um vereinzelte einzelne Halbleitervorrichtungen bereitzustellen, wobei das Schneiden entlang der Länge der länglichen Opferverbindungsstäbe (CB) erfolgt, wobei die lötbare Metallschicht von mindestens einem Teil (100) der Länge der Opferverbindungsstäbe (CB) entfernt wird.

2. Verfahren nach Anspruch 1, wobei die lötbare Metallschicht Zinn umfasst.

3. Verfahren nach dem Anspruch 1 oder Anspruch 2, wobei das Verfahren das Aufwachsen der lötbaren Metallschicht auf der zweiten Oberfläche des gemeinsamen elektrisch leitenden Substrats (12) durch Plattieren umfasst.

4. Verfahren nach einem der vorhergehenden Ansprüche, umfassend das Entfernen der lötbaren Metallschicht mittels Laserablation (LB).

5. Verfahren nach einem der vorhergehenden Ansprüche, umfassend das Entfernen der lötbaren Metallschicht an ausgewählten Stellen (100), die entlang der Länge der Opferverbindungsstäbe (CB) verteilt sind.

6. Verfahren nach Anspruch 5, umfassend das Entfernen der lötbaren Metallschicht von den Opferverbindungsstäben (CB) an Verbindungsstäben (TB), die die länglichen Opferverbindungsstäbe (CB) mit benachbarten Substratabschnitten (120) in dem gemeinsamen elektrisch leitenden Substrat (12) verbinden.

7. Verfahren nach Anspruch 6, umfassend das Entfernen der lötbaren Metallschicht von distalen Enden (100') der Verbindungsstäbe (TB), die die länglichen Opferverbindungsstäbe (CB) mit benachbarten Substratabschnitten (120) in dem gemeinsamen elektrisch leitenden Substrat (12) verbinden.

8. Halbleitervorrichtung, erzielbar mit dem Verfahren nach Anspruch 7, wobei die Halbleitervorrichtung mindestens einen Halbleiterchip umfasst, der auf einer ersten Oberfläche eines Abschnitts (120) eines elektrisch leitenden Substrats (12) angeordnet ist, der eine zweite Oberfläche gegenüber der ersten Oberfläche mit einer auf der zweiten Oberfläche aufgewachsenen lötbaren metallischen Schicht aufweist, wobei der Abschnitt (120) des elektrisch leitenden Substrats (12) restliche Verbindungsstäbe (100') umfasst, die entlang der Länge verteilt sind und von mindestens einer Seite davon hervorsteht, wobei die lötbare Metallschicht an den restlichen Verbindungsstäbe (100') fehlt.

## Revendications

1. Procédé comprenant les étapes suivantes :
disposer une pluralité de puces de semiconducteur sur une première surface d'un substrat commun électriquement conducteur (12), dans lequel le substrat commun (12) a une deuxième surface à l'opposé de la première surface et comprend des parties de substrat adjacentes (120) ayant des côtés en vis-à-vis avec des barrettes de connexion sacrificielles de forme allongée (CB) s'étendant entre les côtés en vis-à-vis adjacents, avec une couche métallique soudable que l'on a fait croître sur la deuxième surface du substrat commun électriquement conducteur (12), la couche métallique soudable s'étendant sur les barrettes de connexion (CB),
supprimer la couche métallique soudable d'au moins une partie (100) de la longueur des barrettes de connexion sacrificielles (CB), et
couper (B, SW) le substrat commun électriquement conducteur (12) comportant la pluralité de puces de semiconducteur disposée sur sa première surface afin de fournir des dispositifs semiconducteurs individuels séparés, la coupe se faisant le long de la longueur des barrettes de connexion sacrificielles de forme allongée (CB) dont la couche métallique soudable est supprimée sur au moins une partie (100) de la longueur des barrettes de connexion sacrificielles (CB).

2. Procédé selon la revendication 1, dans lequel la couche métallique soudable comprend de l'étain.

3. Procédé selon la revendication 1 ou 2, dans lequel le procédé comprend le fait de faire croître la couche métallique soudable sur la deuxième surface du substrat commun électriquement conducteur (12) par galvanisation.

4. Procédé selon l'une quelconque des revendications précédentes, comprenant le fait de supprimer la couche métallique soudable par ablation laser (LB).

5. Procédé selon l'une quelconque des revendications précédentes, comprenant le fait de supprimer la couche métallique soudable en des endroits choisis (100) répartis le long de la longueur des barrettes de connexion sacrificielles (CB).

6. Procédé selon la revendication 5, comprenant le fait de supprimer la couche métallique soudable des barrettes de connexion sacrificielles (CB) au niveau de barrettes de liaison (TB) couplant les barrettes de connexion sacrificielles de forme allongée (CB) à des parties de substrat adjacentes (120) dans le substrat commun électriquement conducteur (12).

7. Procédé selon la revendication 6, comprenant le fait de supprimer la couche métallique soudable des extrémités distales (100') des barrettes de liaison (TB) couplant les barrettes de connexion sacrificielles de forme allongée (CB) à des parties de substrat adjacentes (120) dans le substrat commun électriquement conducteur (12).

8. Dispositif semiconducteur pouvant être obtenu au moyen du procédé de la revendication 7, dans lequel le dispositif semiconducteur comprend au moins une puce de semiconducteur disposée sur une première surface d'une partie (120) d'un substrat commun électriquement conducteur (12) ayant une deuxième surface à l'opposé de la première surface avec une couche métallique soudable que l'on a fait croître sur la deuxième surface, dans lequel la partie (120) de substrat électriquement conducteur (12) comprend les restes de barrettes de liaison (100') répartis le long de la longueur de celui-ci et faisant saillie sur au moins un de ses côtés, la couche métallique soudable étant absente desdits restes de barrettes de liaison (100').
